**Europäisches Patentamt**

**European Patent Office**

**Office européen des brevets**

(19)

(11) Veröffentlichungsnummer: **0 219 659 B1**

(12) **EUROPÄISCHE PATENTSCHRIFT**

(45) Veröffentlichungstag der Patentschrift:
25.10.89

(51) Int. Cl.⁴: **H01L 21/60, H01L 23/48**

(21) Anmeldenummer: **86111977.4**

(22) Anmeldetag: **29.08.86**

(54) **Verfahren zum Herstellen einer Klebekontaktierung.**

(30) Priorität: **27.09.85 DE 3534502**

(43) Veröffentlichungstag der Anmeldung:
**29.04.87 Patentblatt 87/18**

(45) Bekanntmachung des Hinweises auf die Patenterteilung:
**25.10.89 Patentblatt 89/43**

(84) Benannte Vertragsstaaten:
**BE CH DE FR GB IT LI NL**

(56) Entgegenhaltungen:
**EP-A- 0 103 889**
**FR-A- 2 535 110**
**US-A- 3 838 984**

(73) Patentinhaber: **Licentia Patent-Verwaltungs-GmbH, Theodor-Stern-Kai 1, D-6000 Frankfurt/Main 70(DE)**

(72) Erfinder: **Fahrenschon, Kurt, Hirschstrasse 8, D-7914 Pfaffenhofen(DE)**

(74) Vertreter: **Amersbach, Werner, Dipl.-Ing. et al, Licentia Patent-Verwaltungs-GmbH Theodor-Stern-Kai 1, D-6000 Frankfurt 70(DE)**

ACTORUM AG

## Beschreibung

Die vorliegende Erfindung betrifft ein Verfahren nach dem Oberbegriff des Patentanspruchs 1.

Aus der DE-OS 32 43 227 ist es bereits bekannt, integrierte Schaltkreise (IC's) mit Hilfe eines Klebers auf dem Substrat einer Flüssigkristallanzeigezelle (FK-Zelle) zu befestigen. Es ist daraus weiter bekannt, die Leiterbahnen von IC's tragenden Bauteilen mittels eines elektrisch leitfähigen Klebers mit den Leiterbahnen auf dem Substrat der FK-Zelle elektrisch leitend zu verbinden.

Der vorliegenden Erfindung liegt die Aufgabe zugrunde, ein besonders für eine automatisierte Fertigung geeignetes Verfahren zum Aufbringen und Kontaktieren von IC's auf insbesondere aus Glas bestehende Substrate anzugeben.

Diese Aufgabe wird durch die in dem Kennzeichen des Patentspruches 1 angegebenen Merkmale gelöst. Die Ansprüche 2–6 betreffen Ausführungsformen der Erfindung.

Durch die Verwendung eines aus Isoliermaterial bestehenden Rahmens, in dessen Öffnung der IC an seinen Leiterbändchen freitragend aufgehängt ist, ist es in einfacher Weise möglich, die Leiterbändchen an den gewünschten Stellen mit leitfähigem Kleber zu versehen und den IC an die gewünschte Stelle auf dem Substrat zu bringen und die Leiterbändchen elektrisch leitend mit den Leiterbahnen auf dem Substrat zu verbinden.

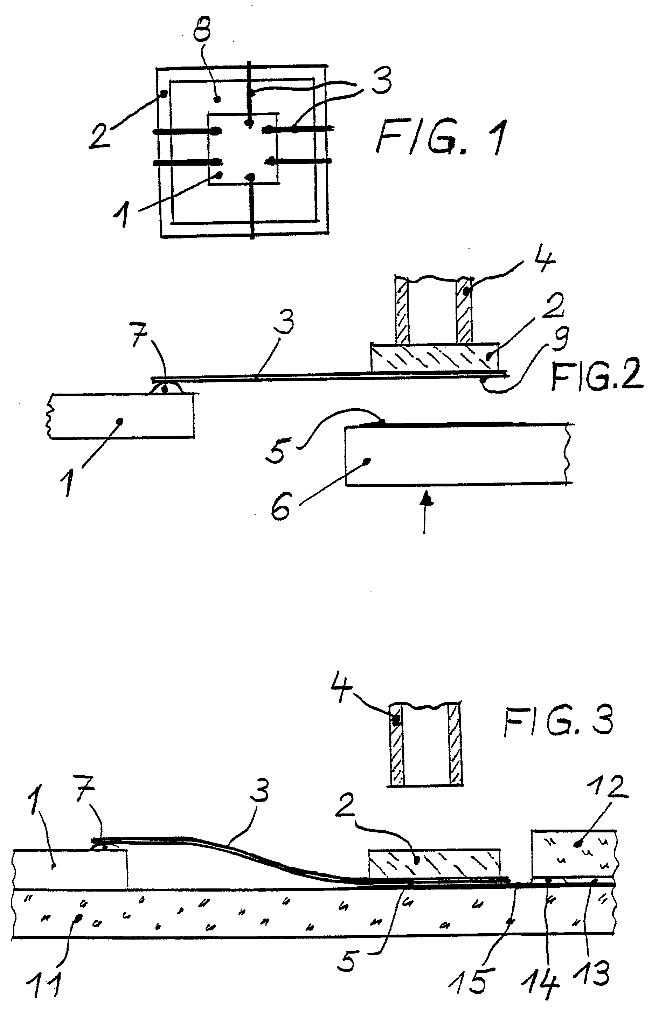

Anhand des in den Figuren 1 bis 3 dargestellten Ausführungsbeispieles wird die Erfindung nachfolgend näher erklärt.

Die Figur 1 zeigt in Aufsicht schematisch einen IC 1, der mittels sechs Leiterbändchen 3 in der Öffnung 8 eines Rahmens 2 aus Isoliermaterial freitragend aufgehängt ist. Der Rahmen 2 kann ein ausgestantzter Teil eines Isolierbandes sein, auf dem eine Vielzahl von IC's konfektioniert angeliefert werden. Bekanntermaßen werden die einzelnen IC's dann durch Stanzen vereinzelt. Die Leiterbändchen 3 sind z. B. durch dünne Kupferbändchen, die an die Kontakte des IC bereits angelötet oder bebondet sind.

Die Figur 2 zeigt nun vergrößert in Seitenansicht, wie die gewünschten Stellen 9 der Leiterbändchen 3 unterhalb des Isolierrahmens 2 mit einer dünnen Schicht eines leitfähigen Klebers versehen werden.

Der Rahmen 2 wird mittels eines Werkzeuges 4, das bevorzugt ein Saugwerkzeug ist, das mittels Unterdruck den Rahmen angesaugt hält, zu einem Träger 6 gebracht, auf dem sich an den gewünschten Stellen eine in der Dicke möglichst maßgenaue Kleberschicht 5 in noch weichem Zustand befindet. Der IC 1 wird mitbewegt, da die Bändchen 3 durch die Kontaktverbindungen 7 mit dem IC einerseits und mit dem Rahmen 2 andererseits, z.B. durch Klebung oder Schweißung verbunden sind. Durch Aufdrücken des Rahmens auf die feuchte Kleberschicht 5 wird im wesentlichen nur der Bereich 9 des Leiterbändchens 3 unterhalb des Rahmens 2 mit Kleber benetzt, da nur in diesem Bereich entsprechender Druck ausgeübt werden kann. Die Bändchen 3 sind nämlich verhältnismäßig dünn und flexibel, z. B. 25μm dick. Die Kleberschicht 5 ist bevorzugt dünner als die Dicke des Bändchens, z. B. 15μmdick. Dadurch kann vermieden werden, daß bei großflächiger Kleberschicht 5 auch die zwischen den Bändchen 3 befindlichen Oberflächen des Rahmens 2 benetzt werden, was zu unerwünschten Kurzschlüssen führen würde.

Nach dem Benetzen der gewünschten Bereiche 9 der Bändchen mit dem leitfähigen Kleber 5 wird der Rahmen 2 und damit der IC 1 mittels der Werkzeuges 4 nunmehr auf das Substrat 11 der FK-Zelle überführt und an der gewünschten Stelle aufgedrückt, wodurch gleichzeitig die gewünschten elektrischen Verbindungen mit den Leiterbahnen 15 auf dem Substrat 11 der FK-Zelle hergestellt werden.

Die Figur 3 zeigt den fertigen Aufbau nach Abheben des Werkzeues 4. Die FK-Zelle besteht aus zwei Glasplatten 12 und 11, zwischen welchen sich das FK-Material 13 befindet. Durch Verkittungen 14 ist das Flüssigkristallmaterial eingeschlossen. Die Leiterbahnen befinden sich auf dem Substrat 11 und sind durch die Kittung 14 aus dem Inneren der FK-Zelle herausgeführt. Das Substrat 11 ist größer als das Substrat 12 und ist zum direkten Aufbringen der Ansteuer-IC's mit entsprechenden Leiterbahnen und Kontakten versehen. Die mit dem feuchten Kleber benetzten Bereiche 9 der Bändchen 3 sind auf die Leiterbahnen 15 der FK-Zelle aufgedrückt und damit elektrisch kontaktiert aufgeklebt, nachdem der Kleber ausgehärtet bzw. erhärtet ist. Der IC 1 kann ggf. noch durch zusätzliche Mittel, wie z.B. Kleber gegen Erschütterungen, gesichert auf dem Substrat 11 befestigt werden. Der verbleibende Isolierrahmen 2 bildet einen bleibenden Schutz der Klebekontaktstellen.

## Patentansprüche

1. Verfahren zum Aufbringen eines in der Öffnung eines Rahmens aus Isoliermaterial mittels freitragender Leiterbändchen aufgehängten IC auf die Oberfläche eines mit elektrischen Leiterbahnen versehenen Substrats einer Flüssigkristallanzeigezelle (FK-Zelle) in der Weise, daß ein elektrischer Kontakt zwischen den Leiterbahnen des Substrats und den Leiterbändchen des IC hergestellt wird, <u>dadurch gekennzeichnet</u>, daß der Rahmen mit der Oberfläche, auf der die Leiterbändchen des IC befestigt sind, derart auf einen eine leitfähige Kleberschicht aufweisenden Träger gedrückt wird, daß im wesentlichen nur die Bereiche der Leiterbändchen des IC, die sich auf der Oberfläche des Rahmens befinden, mit leitfähigem Kleber benetzt werden, daß dann der Rahmen mit dem IC und den mit Kleber benetzten Leiterbändchen auf das Substrat überführt und so positioniert wird, daß die mit Kleber benetzten Leiterbändchen auf entsprechend angeordnete Leiterbahnenteile des Substrats aufgedrückt werden und daß dann der Kleber erhärtet bzw. ausgehärtet und dadurch eine dauerhafte elektrische Verbindung zwischen den Leiterbändchen des IC und den Leiterbahnen des Substrats hergestellt wird.

2. Verfahren nach Anspruch 1, dadurch gekennzeichnet, daß als Substrat eine als Deckplatte der FK-Zelle dienende Glasplatte verwendet wird.

3. Verfahren nach Anspruch 1 oder Anspruch 2, dadurch gekennzeichnet, daß ein Substrat verwendet wird, dessen Leiterbahnen dünner als 10μm, insbesondere dünner als 6μm sind.

4. Verfahren nach einem der Ansprüche 1 bis 3, dadurch gekennzeichnet, daß der Rahmen belassen wird und die Klebeverbindungsbereiche zumindest teilweise durch den Rahmen überdeckt werden.

5. Verfahren nach einem der Ansprüche 1 bis 4, dadurch gekennzeichnet, daß die Leiterbändchen des IC zur Kleberaufnahme auf eine Kleberschicht gedrückt werden, deren Dicke geringer ist als die Dicke der Leiterbändchen.

6. Verfahren nach einem der Ansprüche 1 bis 5, dadurch gekennzeichnet, daß die Kleberschicht des Trägers aus mehreren diskreten Schichtteilen besteht, die entsprechend den gewünschten Kontaktstellen zuvor auf die Oberfläche des Trägers aufgebracht werden.

## Claims

1. Method for the application of an integrated circuit, which is suspended in the opening of a frame of insulating material by means of flying conductor ribbons, onto the surface of a substrate, which is provided with electrical conductor tracks, of a liquid crystal indicator cell (liquid crystal cell) in such a manner that an electrical contact is produced between the conductor tracks of the substrate and the conductor ribbons of the integrated circuit, characterised thereby, that the frame is pressed by the surface, on which the conductor ribbons of the integrated circuit are fastened, in such a manner onto a carrier displaying a conductive adhesive layer that substantially only those regions of the conductor ribbons of the integrated circuit, which are situated on the surface of the frame, are wetted by conductive adhesive substance, that the frame with the integrated circuit and the conductor ribbons wetted by adhesive substance is moved over onto the substrated and so positioned that the conductor ribbons wetted by adhesive substance are pressed onto correspondingly arranged conductor tracks of the substrate and that the adhesive substance is then set or cured and a durable electrical connection is thereby produced between the conductor ribbons of the integrated circuit and the conductor tracks of the substrate.

2. Method according to claim 1, characterised thereby, that a glass plate, which serves as cover plate of the liquid crystal cell, is used as substrate.

3. Method according to claim 1 or claim 2, characterised thereby, that a substrate is used, the conductor tracks of which are thinner than 10 micrometers, in particular thinner than 5 micrometres.

4. Method according to one of the claim 1 to 3, characterised thereby, that the frame is left as it was and the adhesive connection regions are at least partially covered by the frame.

5. Method according to one of the claims 1 to 4, characterised thereby, that the conductor ribbons of the integrated circuit are for reception of the adhesive substance pressed onto an adhesive layer, the thickness of which is less than the thickness of the conductor ribbons.

6. Method according to one of the claims 1 to 5, characterised thereby, that the adhesive layer of the carrier consists of several discrete layer parts which were previously applied onto the surface of the carrier in correspondence with the desired contact places.

## Revendications

1. Procédé pour appliquer un circuit intégré, suspendu librement dans l'ouverture d'un cadre en matériau isolant par de petits rubans conducteurs, sur la surface d'un substrat, pourvu de pistes conductives électriques, d'une cellule d'affichage à cristal liquide (cellule CL), de manière que des contacts électriques soient établis entre les pistes conductives du substrat et les rubans conducteurs du CI, caractérisé en ce que le ruban est pressé sur un support portant une couche d'adhésif conducteur par la surface sur laquelle sont fixés les rubans conducteurs du CI, de manière que, pour l'essentiel, seules les zones des rubans conducteurs du CI se trouvant sur la surface du cadre soient mouillées par l'adhésif conducteur, que le cadre avec le CI et les rubans mouillés d'adhésif, sont transférés au substrat et sont positionnés de manière que les rubans conducteurs mouillés d'adhésif soient pressés sur des parties de pistes conductives disposées selon les besoins du substrat et que, ensuite, on produit la prise ou le durcissement complet de l'adhésif, en établissant ainsi des liaisons électriques durables entre les rubans conducteurs du CI et les pistes conductives du substrat.

2. Procédé selon la revendication 1, caractérisé en ce que le substrat est une lame de verre servant de plaque de recouvrement de la cellule CL.

3. Procédé selon la revendication 1 ou 2, caractérisé en ce que les pistes conductives du substrat ont une épaisseur inférieure à 10 μm, en particulier une épaisseur inférieure à 6 μm.

4. Procédé selon une des revendications 1 à 3, caractérisé en ce que le cadre est laissé dans sa disposition de départ et est intégré avec les rubans dans les liaisons établies, de sorte que les zones de liaison par collage sont au moins partiellement recouvertes par le cadre.

5. Procédé selon une des revendications 1 à 4, caractérisé en ce que, en vue de leur mouillage par l'adhésif, les rubans conducteurs du CI sont pressés sur une couche d'adhésif dont l'épaisseur est inférieure à l'épaisseur des rubans.

6. Procédé selon une des revendications 1 à 5, caractérisé en ce que la couche d'adhésif du support est formée de plusieurs parties discrètes qui ont été appliquées préalablement sur la surface du support en fonction des points de contact désirés.

FIG. 1

FIG.2

FIG. 3